(19) Europäisches Patentamt / European Patent Office / Office européen des brevets

(11) **EP 2 706 485 B1**

(12) **EUROPEAN PATENT SPECIFICATION**

(45) Date of publication and mention of the grant of the patent:
**08.06.2016 Bulletin 2016/23**

(51) Int Cl.:
*G06K 19/07* (2006.01)       *G01R 31/28* (2006.01)
*H01Q 1/22* (2006.01)        *G06K 7/00* (2006.01)
*G01R 31/302* (2006.01)

(21) Application number: **13003269.1**

(22) Date of filing: **27.06.2013**

(54) **Determining electrical parameters of a contactless card**

Bestimmung der elektrischen Parameter einer kontaktlosen Karte

Détermination des paramètres électriques d'une carte sans contact

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.09.2012 CH 15832012**

(43) Date of publication of application:
**12.03.2014 Bulletin 2014/11**

(73) Proprietor: **Legic Identsystems AG**
**8620 Wetzikon (CH)**

(72) Inventor: **Aebischer, Hubert A.**
**CH-8620 Wetzikon (CH)**

(74) Representative: **Rentsch Partner AG**
**Rechtsanwälte und Patentanwälte**
**Fraumünsterstrasse 9**
**Postfach 2441**
**8022 Zürich (CH)**

(56) References cited:
**WO-A1-2005/086279**

**Description**

**FIELD OF THE INVENTION**

The present invention relates to an apparatus and a method of determining one or more parameters of a contactless data storage device.

**BACKGROUND ART**

Contactless data storage devices, hereinafter also referred to as "contactless cards", such as for example RFID transponders (RFID: Radio Frequency Identification), are widely used in access control systems and other applications. Using a read/write device, data stored in a microchip of the contactless card is accessed via an electromagnetic field, which is transmitted between an antenna of the read/write device and an antenna of the contactless card.

The quality and behaviour of contactless cards depends on electrical parameters of the contactless cards. Important electrical parameters include, for example, the inductance of the antenna of the contactless card. The inductance of the antenna determines the operating resonance frequency of a contactless card, which is required to be sufficiently close to the carrier frequency of the RFID system.

In order to measure electrical parameters of a contactless card, for example the inductance of the antenna, electrical components of the cards need to be electrically connected to measurement equipment. For many electrical parameters to be determined, the contactless card needs to be carefully opened in order to electrically connect measurement equipment. After opening the contactless card, the card is normally destroyed. Accordingly, after measuring the electrical parameters of a contactless card, the contactless card cannot be used anymore. Determining the electrical parameters is relatively slow, as the contactless card has to be carefully opened.

WO 2005/086279 discloses measuring a characteristic parameter of a resonant structure. The resonant structure is placed at a location in the far field of a first and second antenna. Electromagnetic waves are emitted with different frequencies by means of the first antenna. The resonant structure modifies the electromagnetic waves. During a first step, a first electric power-value being representative of the power associated with the emitted electromagnetic waves is determined. During a second step, a second electric power-value being representative of the power associated with the received modified electromagnetic waves. At least one characteristic is determined using the first and second power-values.

**DISCLOSURE OF THE INVENTION**

It is an object of the present invention to provide an apparatus and a method of determining electrical parameters of a contactless data storage device, which do not have at least some of the disadvantages in the prior art. In particular it is an object of the present invention to provide an apparatus and a method of determining electrical parameters of a contactless data storage device, such that the contactless data storage device does not need to be destroyed in order to measure the electrical parameters. In particular it is an object of the present invention to provide an apparatus and a method of determining electrical parameters of a contactless data storage device, wherein the electrical parameters are determined via contactless interaction with the contactless data storage device. In particular it is an object of the present invention to provide an apparatus and a method of determining electrical parameters of a contactless data storage device, wherein the electrical parameters are determined faster than in prior art.

According to the present invention, these objects are achieved through the features of the independent claims. In addition, further advantageous embodiments follow from the dependent claims and the description.

According to the present invention, an apparatus for determining one or more electrical parameters of a contactless data storage device comprises: an impedance analyzer configured to measure impedance data of a pick-up probe interacting via an electromagnetic field with the contactless data storage device and to determine measured impedance data as a function of at least one of: frequency, current, and voltage; a simulator unit configured to determine calculated impedance data of a computerized model of the pick-up probe interacting via a modelled electromagnetic field with a computerized model of the contactless data storage device, the calculated impedance data being determined as a function of one or more electrical parameters of the computerized model of the contactless data storage device and as a function of at least one of: frequency, current, and voltage; a function generator configured to generate an objective function using the measured impedance data and using the calculated impedance data; and an optimizer unit configured to determine an optimal solution for the objective function and to use the optimal solution to calculate the one or more electrical parameters of the contactless data storage device. Accordingly, the contactless data storage device is only required to be in interaction with the pick-up probe via an electromagnetic field. It is not required to open or destroy the contactless data storage device to determine electrical parameters. Hence, after determining the electrical parameters of a contactless storage device, the contactless storage device can still be used. Moreover, in order to determine the one or more electrical parameters of the contactless data storage device, the geometry of the antenna included in the contactless data storage device does not have to be known.

In an embodiment, the simulator unit includes a data store configured to store one or more exemplary impedance data sets of one or more exemplary microchips of contactless data storage devices, an exemplary impedance data set being stored as a function of at least one of: frequency, current, and voltage; and, depending on the microchip included in the contactless data storage device, one of the stored exemplary impedance data sets is used to calculate the impedance data of the computerized model of the pick-up probe. In particular, certain types of microchips are used in contactless data storage devices. Each type has specific electrical parameters. However, microchips of the same type have very similar electrical parameters. Hence, as an exemplary impedance data set of a microchip is sufficiently close to the impedance of any microchip of the same type, a computerized model of the contactless data storage device comprising a microchip of a certain type may be described sufficiently accurate on the basis of an exemplary impedance data set of an exemplary microchip.

In an embodiment, the simulator unit includes one or more approximation units each configured to approximate an electrical parameter of the contactless data storage device, the approximated electrical parameter depending on one or more electrical parameters of the contactless data storage device. The approximation may include an analytical model of electrical parameters of the contactless data storage device. Depending on the complexity of the model used for modelling the contactless data storage device, the optimizer unit needs to solve an optimization problem for a considerable number of electrical parameters of the contactless data storage device. By means of the one or more approximation units, the complexity of the optimization problem can be reduced, wherein in particular electrical parameters of the contactless data storage device can be determined faster.

In an embodiment, the function generator is configured to generate the objective function using only the imaginary part of the measured impedance data and the imaginary part of the calculated impedance data. The accuracy of the determined electrical parameters is thereby improved because the real part of the impedance of the pick-up coil used to measure the impedance data is more prone to statistical spread than is the imaginary part, which nearly behaves as an ideal inductance.

In an embodiment, the optimizer unit is configured to determine the one or more electrical parameters of the contactless data storage device with an accuracy which depends on one or more parameters of the contactless data storage device, in particular on one or more parameters of a microchip of the contactless data storage device.

In an embodiment, the apparatus further comprises a tuning quality calculator configured to use the one or more electrical parameters of the contactless data storage device to calculate a tuning quality of the contactless data storage device. After determining electrical parameters of a contactless data storage device, the tuning quality of the contactless data storage device is readily available.

In an embodiment, the apparatus further comprises a required operating field strength calculator configured to use the one or more determined electrical parameters of the contactless data storage device to calculate a minimal required operating field strength $H_{op}$ of the contactless data storage device. After determining electrical parameters of a contactless data storage device, the required operating field strength of the contactless data storage device is readily available.

In an embodiment, the apparatus further comprises an impedance mapping amplifier configured to amplify the output voltage of an impedance analyzer such that the impedance of an exemplary microchip is measured by the impedance analyzer at higher voltages than provided by the impedance analyzer, wherein in particular the impedance mapping amplifier is configured to amplify an input voltage $U_{in}$ to the impedance mapping amplifier by a complex factor $\mu$ to an output voltage $U_{out} = \mu\, U_{in}$ and to amplify an input current $I_{in}$ to the impedance mapping amplifier by a complex factor $\lambda$ to an output current $I_{out} = \lambda\, I_{in}$, wherein preferably $\mu/\lambda = 1$. In a variant, the impedance of the exemplary microchip is to be measured at a voltage of up to $5V_{rms}$. However, available impedance analyzers operate at output voltages of $1V_{rms}$ maximum. Through the impedance mapping amplifier, the exemplary microchip can be measured at higher voltages than the voltages provided by impedance analyzers available on the market.

In addition to an apparatus, the invention relates to a method of determining electrical parameters of a contactless data storage device. The method comprises: measuring impedance data of a pick-up probe interacting via an electromagnetic field with the contactless data storage device and determining measured impedance data as a function of at least one of: frequency, current, and voltage; calculating impedance data of a computerized model of the pick-up probe interacting via a modelled electromagnetic field with a computerized model of the contactless data storage device, wherein calculated impedance data is determined as a function of one or more electrical parameters of the computerized model of the contactless data storage device and as a function of at least one of: frequency, current, and voltage; generating an objective function using the measured impedance data and using the calculated impedance data; and calculating an optimal solution for the objective function and using the optimal solution to determine the one or more electrical parameters of the contactless data storage device.

In a variant, the method further comprises: storing in a data store one or more exemplary impedance data sets of one or more exemplary microchips of contactless data storage devices, an exemplary impedance being stored as a function of at least one of: frequency, current, and voltage; and, depending on the microchip included in the contactless data storage device, using one of the stored exemplary impedance data sets to calculate the impedance data of the computerized model of the pick-up probe.

In a variant, the method further comprises: approximating an electrical parameter of the contactless data storage device, the approximated electrical parameter depending on one or more electrical parameters of the contactless data storage device.

In a variant, generating the objective function is performed using the imaginary part of the measured impedance data and the imaginary part of the calculated impedance data.

In a variant, one or more electrical parameters of the contactless data storage device is determined with an accuracy which depends on one or more parameters of the contactless data storage device, in particular on one or more parameters of a microchip of the contactless data storage device.

In a variant, the method further comprises: using the one or more electrical parameters of the contactless data storage device to calculate a tuning quality of the contactless data storage device.

In a variant, the method further comprises: using the one or more electrical parameters of the contactless data storage device to calculate a minimal required operating field strength $H_{op}$ of the contactless data storage device.

In addition to an apparatus and a method of determining electrical parameters of a contactless card, the invention relates to a computer program product comprising a computer readable medium having stored thereon computer program code for controlling one or more processors of an apparatus for determining one or more electrical parameters of a contactless data storage device. The computer program code is configured to direct the apparatus to: measure impedance data of a pick-up probe interacting via an electromagnetic field with the contactless data storage device and determine measured impedance data as a function of at least one of: frequency, current, and voltage; calculate impedance data of a computerized model of the pick-up probe interacting via a modelled electromagnetic field with a computerized model of the contactless data storage device, the calculated impedance data being determined as a function of one or more electrical parameters of the computerized model of the contactless data storage device and as a function of at least one of: frequency, current, and voltage; generate an objective function using the measured impedance data and using the calculated impedance data; and calculate an optimal solution for the objective function and using the optimal solution to determine the one or more electrical parameters of the contactless data storage device.

**BRIEF DESCRIPTION OF THE DRAWINGS**

The herein described invention will be more fully understood from the detailed description given herein below and the accompanying drawings which should not be considered limiting to the invention described in the appended claims. The drawings are showing:

Fig. 1a    schematically a pick-up probe connected to an impedance analyzer;

Fig. 1b    schematically a contactless data storage device;

Fig. 1c    schematically an apparatus for determining electrical parameters of a contactless data storage device;

Fig. 2    an example of the measurement of the impedance of the pick-up probe being in interaction with the contactless card via an electromagnetic field;

Fig. 3    the equivalent circuit of a pick-up probe which is in interaction with a contactless data storage device via an electromagnetic field;

Fig. 4    the equivalent circuit of an impedance mapping amplifier configured to amplify the output voltage of an impedance analyzer and to measure the impedance of a microchip at higher voltages;

Fig. 5    an example measurement of the real part of the impedance of a microchip for various currents and frequencies;

Fig. 6    an example measurement of the imaginary part of the impedance of a microchip for various currents and frequencies; and

Fig. 7    an exemplary sequence of steps for determining one or more electrical parameters of a contactless data storage device.

## MODE(S) FOR CARRYING OUT THE INVENTION

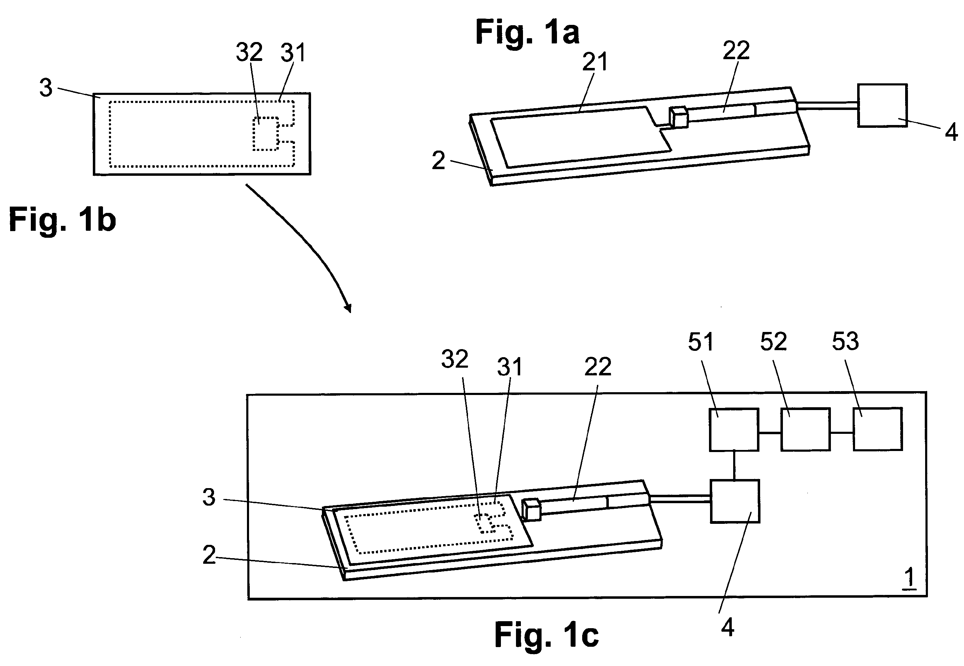

Figure 1 a shows schematically a pick-up probe 2 connected to an impedance analyzer 4. For example, the pick-up probe 2 includes an ISO-calibration coil (ISO: International Organization for Standardization). For example, the impedance analyzer 4 includes commercially available equipment. The pick-up probe 2 includes a probe antenna 21 and a probe connector 22 for connecting the probe antenna 2 to the impedance analyzer 4. For example, the pick-up probe 2 includes a printed circuit board. The probe antenna 21 includes a coil of one or more windings.

Figure 1 b shows schematically a contactless data storage device 3. The contactless data storage device 3, hereinafter referred to as "contactless card", includes a card antenna 31 for inductive coupling with a read/write device. The card antenna 31 includes a coil of one or more windings and is connected to a card microchip 32, which includes a data store containing stored data, e.g. product identification data or user identification data. For example, the contactless card 3 is an RFID tag or an RFID transponder, implemented in the form of a label, (smart) card, bracelet, key tag, etc. For example, the contactless card 3 is configured to interact with a reader/writer via a standardized RFID protocol as defined in standards such as ISO 18092, ISO 15693, or ISO 14443. For example, the contactless card 3 is configured to receive electromagnetic field pulses having a carrier frequency in the range of 100 kHz to 2.5GHz. Particularly, the carrier frequency is set to the working frequency of an RFID system, e.g. 6.78MHz, 13.56MHz, or 27.1 2MHz (or another multiple of 13.56MHz).

Figure 1c shows schematically an apparatus 1 for determining electrical parameters of a contactless card 3. The apparatus 1 includes a pick-up probe 2, an impedance analyzer 4, a simulator unit 51, a function generator 52, and an optimizer unit 52.

As illustrated schematically in Figure 1 c, the pick-up probe 2 is configured to interact with the contactless data storage device 3 in particular via an electromagnetic field, namely via an electromagnetic field between the probe antenna 21 of the pick-up probe 2 and the card antenna 31 of the contactless card 3. For example, as schematically shown in Figure 1 c, the contactless card 3 is arranged on the pick-up probe 2 in order to provide for interaction between the pick-up probe 2 and the contactless card 3. The probe antenna 21 and the card antenna 31 are arranged within a distance which is close enough that an interaction via an electromagnetic field between the pick-up probe 2 and the contactless card 3 is enabled.

In a variant, which relates to Figure 1 a, a short calibration is performed, wherein the impedance analyzer 4 is connected to the pick-up probe 2, but without arranging a contactless card 3 on the pick-up probe 2. The calibration is performed in order to compensate for the dominating part of the measured impedance, which originates from the inductivity L, of the pick-up probe 2 and generates an inclined line both in the real part and the imaginary part of the frequency response of the measured impedance. In a variant, the simulator unit 51 is configured to store calibration data according to the short calibration.

The pick-up probe 2 and the contactless card 3 are arranged close together, which assures a high magnetic coupling between the probe antenna 21 and the card antenna 31. This implies that additionally to the magnetic coupling, a capacitive coupling between the probe antenna 21 and the card antenna 31 is to be taken into consideration as well.

The impedance analyzer 4 is configured to measure the impedance of the pick-up probe 2, wherein frequency scans and voltage scans are preformed. For example, 201 frequencies in the range of 10MHz to 20MHz are measured and 21 voltages are measured. In a variant, any other number of frequencies and/or voltages are measured. In a variant, the number of measured voltages is relatively small with respect to the number of measured frequencies, for example a factor of ten smaller or any other factor. In a variant, the number of measured voltages depends on the type of the card microchip 32 of the contactless card 3.

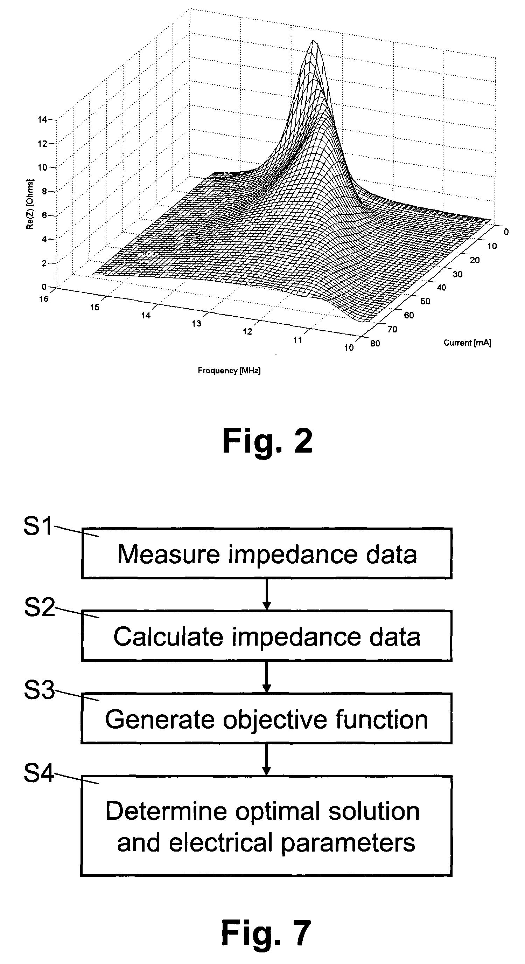

Figure 2 shows an example of the measurement of the impedance of the pick-up probe 2 being in interaction with the contactless card 3 via an electromagnetic field. In Figure 2, the real part of the measured impedance data of the pick-up probe 2 having a contactless card 3 on it is shown as a function of frequency and current. It is visible that the resonance frequency decreases with increasing current, wherein the resonance is damped more and more, and, as a result of the nonlinearity of the card microchip 32 of the contactless card 3, the resonance curve becomes wider and more asymmetrical, contrary to a typical resonance curve.

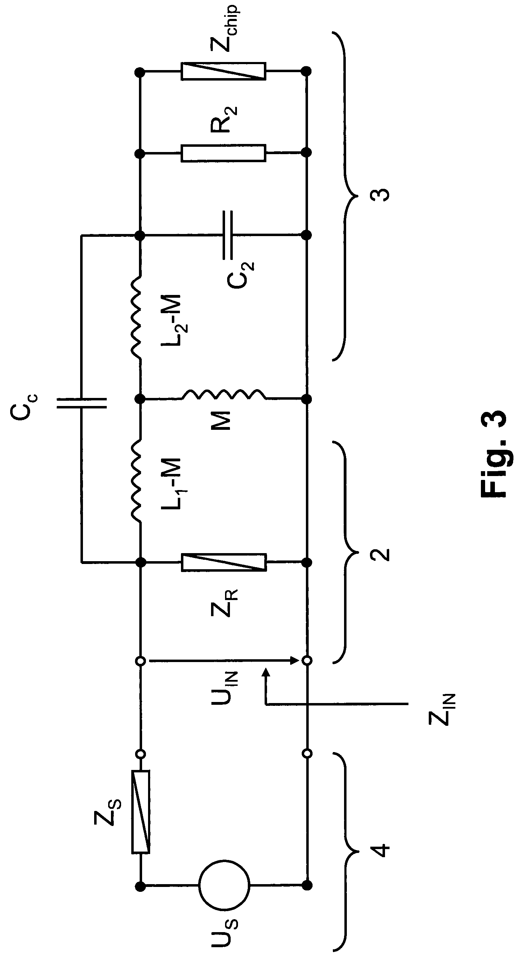

Figure 3 shows the equivalent circuit of a pick-up probe 2 which is in interaction with a contactless data storage device 3 via an electromagnetic field. The equivalent circuit is used as a model of the pick-up probe 2 being in interaction with the contactless card 3. As indicated in Figure 3, the impedance $Z_{IN}$ of the pick-up probe 2 and the contactless card 3 is measured, in particular as a function of the frequency for different source volt-ages of the impedance analyzer 4. As shown schematically in Figure 3, the impedance analyzer 4 is modelled to include a voltage source $U_s$ and a source impedance $Z_S$. $U_{IN}$ is the voltage at the input terminals of the pick-up probe 2. $Z_{IN}$ is the impedance of the pick-up probe 2 with a contactless card 3 arranged on it. $Z_R$ is the remaining impedance of the pick-up probe 2 after deducting its inductance $L_1$ (cf. to description below). $Z_R$ depends on a capacitance $C_1$ and a resistance $R_1$ of the pick-up probe 2. M is the mutual inductance between the probe antenna 21 of the pick-up probe 2 and the card antenna 31 of the contactless card 3. $C_c$ is the coupling capacitance between the probe antenna 21 and the card antenna 31. In particular,

$L_2$, $C_2$, and $R_2$ are electrical parameters of interest of the contactless card 3, namely the inductivity, the capacitance, and the resistance of the card antenna 31 of the contactless card 3. $Z_{chip}$ is the impedance of the card microchip 32 of the contactless card 3.

The impedance $Z_{IN}$ depends strongly on the impedance of the pick-up probe 2, because the measurement is performed using a direct connection with the probe connector 22 of the pick-up probe 2, and because coupling between the pick-up probe 2 and the contactless card 3 is established only indirectly via the electromagnetic field between the probe antenna 21 of the pick-up probe 2 and the card antenna 31 of the contactless card 3. Hence, the impedance of the pick-up probe 2 is to be determined as precisely as possible, such that an accurate value of the impedance can be used in further calculations. Accordingly, the short calibration of the impedance analyzer 4 is to be established as accurately as possible.

Normally, the equivalent circuit with an inductance $L_1$, a parallel capacitance $C_1$, and a parallel resistance $R_1$ is not sufficient, because in reality the resistance R, is not constant, but depends on the frequency. Therefore, the precise impedance of the pick-up probe 2 alone, which is denoted by $Z_{calib}$, is measured with the impedance analyzer as a function of the frequency f. The real part is fitted using a polynomial of 1 st order, having coefficients a and b, the imaginary part is determined using the parallel circuit comprising the inductance $L_1$ and the capacitance $C_1$. In the following, f denotes the frequency and w denotes the angular frequency $2\pi f$.

$$Z_{calib} = a \cdot f + b - \frac{i}{\omega C_1 - \frac{1}{\omega L_1}} \qquad (1)$$

As shown in Figure 3, the inductance $L_1$ is considered separately in the equivalent circuit. Accordingly, the inductance is deducted in order to determine the impedance $Z_R$ without the inductance $L_1$.

$$Z_R = \frac{1}{\frac{1}{Z_{calib}} - \frac{1}{i\omega L_1}} \qquad (2)$$

The impedance $Z_R$ has to be determined only once and is then used in the equivalent circuit accordingly.

$Z_{IN}$ is measured with the contactless card 3 arranged on the pick-up probe 2 for various frequencies and source voltages $U_S$ and an optimization problem for the five unknown electrical parameters $L_2$, $C_2$, $R_2$, M, and $C_c$ is defined. In order to accelerate the optimization problem, the number of electrical parameters to be determined can be reduced from five to two using analytical formulas, such that only $L_2$ and M remain as electrical parameters which have to be determined. Particularly, $C_2$, $R_2$, and $C_c$ can be calculated depending on $L_2$ and M in a good approximation as follows.

$C_2$ is determined using the measured non-operating resonance frequency $f_{nop}$.

$$C_2 = \frac{1}{4\pi^2 f_{nop}^2 L_2} - C_{nop} \qquad (3)$$

The non-operating resonance frequency $f_{nop}$ of the contactless card 3 is to be determined with a weak coupling and a very low source voltage from the impedance analyzer, such that essentially no voltage is applied to the card microchip 32. For example, the pick-up probe 2 and the contactless card 3 are arranged at a distance of about 30mm and the impedance analyzer 4 is adjusted to a source voltage $U_s$ of $5mV_{rms}$. In this case, the coupling capacitance $C_c$ can be neglected and does not have to be taken into account in above equation. $C_{nop}$ is the equivalent non-operating capacitance of the card microchip 32 measured at a voltage of $5mV_{rms}$ and at the non-operating resonance frequency $f_{nop}$.

The coupling capacitance $C_c$ between the pick-up probe 2 and the contactless card 3 can be approximatively determined assuming that the coupling capacitance $C_c$ is in parallel to the capacitance $C_2$.

$$C_c = \frac{1}{4\pi^2 f_{nop\_Calib}^2 L_2} - \left(C_2 + C_{nop}\right) \qquad (4)$$

$f_{nop\_Calib}$ is the non-operating resonance frequency of the contactless card 3 measured using the pick-up probe 2 in the arrangement as shown in Figure 1 c, i.e. wherein the contactless card 3 is arranged on the pick-up probe 2 with practically no distance between the pick-up probe 2 and the contactless card 3, using a source voltage $U_s$ of the impedance analyzer 4 of $5mV_{rms}$. Because of the strong coupling, the non-operating resonance frequency $f_{nop\_Calib}$ is slightly smaller than the non-operating resonance frequency $f_{nop}$ in case of a weak coupling.

The total resistance $R_{2tot}$ of the contactless card 3 including the card microchip 32 is calculated by means of the measured non-operating quality factor $Q_{nop\_Calib}$ using the known relation for a parallel resonator.

$$R_{2tot} = Q_{nop\_Calib} \cdot \sqrt{\frac{L_2}{C_2 + C_{nop}}} \quad (5)$$

$Q_{nop\_Calib}$ is the non-operating quality factor of the contactless card 3 measured with the pick-up probe 2 using a source voltage of the impedance analyzer 4 of $5mV_{rms}$ in the arrangement according to Figure 1 c, i.e. wherein the contactless card 3 is arranged on the pick-up probe 2 with practically no distance between the pick-up probe 2 and the contactless card 3.

The parallel equivalent resistance $R_{nop}$ of the card microchip 32 measured at $5mV_{rms}$ and at the non-operating resonance frequency $f_{nop}$ can be used to determine an estimated value for the resistance $R_2$, which is denoted by $R_{2est}$.

$$R_{2est} = \frac{R_{2tot} \cdot R_{nop}}{R_{nop} - R_{2tot}} \quad (6)$$

Using the estimated resistance $R_{2est}$, the exact resistance $R_2$ of the contactless card 3 can be calculated, wherein coupling between both of the resonance circuits is taken into account. The formula is determined using an analytical determination of the impedance of two coupled resonance circuits as follows.

$$R_2 = R_{2est} \cdot \left( 1 + \left( \frac{M}{L_2 C_2} \right)^2 \cdot \left( \frac{\frac{C_1}{R_{2est}} + \frac{C_2}{R_1}}{\gamma_2} \right) \right) \quad (7)$$

As follows, $\gamma_2$ is the known damping factor of the resonance formula of the second resonance circuit, wherein the estimated resistance $R_{2est}$ is to be used as the value of the resistance $R_2$ which is not known before evaluation of equation (7).

$$\gamma_2 = \frac{1}{R_{2est} C_2} \quad (8)$$

In principle, iteration of equations (7) and (8) may be performed in order to increase accuracy.

Using the impedance analyzer, measurements $Z_{IN}(I,f)$ of the input impedance of the pick-up probe 2 with arranged contactless card 3 are performed. The measurements $Z_{IN}(I,f)$ of the input impedance depend on the current and the frequency. A global optimization problem is to be solved in order to determine the electrical parameters $L_2$, $C_2$, $R_2$, $M$, and $C_c$ of the contactless card 3. Accordingly, a mathematical model is defined for the measurements $Z_{IN}(I,f)$ of the input impedance using the nonlinear characteristic of the impedance $Z_{chip}(I,f)$ of the card microchip 32. Using the mathematical model, the electrical parameters $L_2$, $C_2$, $R_2$, $M$, and $C_c$ of the contactless card 3 are varied until quadratic differences between the computerized model and the measurement are minimal.

For contactless cards, various types of card microchips 32 exist. For each type, the impedance $Z_{chip}(I,f)$ of an exemplary card microchip 32 is determined using a measurement equipment which will be described later on, wherein for any contactless card 3 with a certain type of a card microchip 32, the determined impedance $Z_{chip}(I,f)$ of the exemplary card microchip 32 is used to determine the computerized model of the input impedance $Z_{IN}(I,f)$ of the pick-up probe 2 having a contactless card 3 arranged on it.

Using the analytical equations (3), (4), and (7), the dimensions of the optimization problem are reduced from the five electrical parameters $L_2$, $C_2$, $R_2$, M, and $C_c$ to the two electrical parameters $L_2$ and M, as by the analytical equations the electrical parameters $C_2$, $R_2$, and $C_c$ are expressed using the electrical parameters $L_2$ and M. By the reduction of the dimensions and by a sequential partitioning of two-dimensional intervals of $L_2$ and M, the solution to the optimization problem can be determined in short time, e.g. using a standard PC running the simulation application MATLAB.

Those values of $L_2$ and M where the difference of the surface of the imaginary part of the calculated input impedance $Z_{IN}(l,f)$ and of the measured input impedance is minimal represent the solution of the optimization problem. Using this solution, the remaining electrical parameters $C_2$, $R_2$, and $C_c$ of the contactless card 3 may be determined using analytical equations (3), (4), and (7).

In order to achieve the best possible accuracy, only the imaginary part of the impedance surface is used to calculate residuals, because the imaginary part is better repeatable than the real part. Any procedure which provides for reduction of the minimal value of residuals provides for a better stability of the optimization procedure and improvements with regard to accuracy.

Using the electrical parameters of the contactless card 3, the operating resonance frequency $f_{op}$ may be determined, which is the resonance frequency that is obtained when the card microchip 32 receives the minimal voltage $U_{op}$ required for operation. The difference of the operating resonance frequency $f_{op}$ to the carrier frequency $f_0$, e.g. to 13.56MHz, is a measure of the tuning quality of the contactless card 3.

Alternatively, the non-operating resonance frequency $f_{nop}$, which is the resonance frequency obtained when the card microchip 32 receives practically no voltage, may be determined and used as a measure of the tuning quality of the contactless card 3. The non-operating resonance frequency $f_{nop}$ is much easier to measure than the operating resonance frequency $f_{op}$. However, an optimum non-operating resonance frequency $f_{nop\_opt}$ is not just equal to the carrier frequency $f_0$, e.g. 13.56 MHz. Rather, the optimum non-operating resonance frequency $f_{nop\_opt}$ depends on the inductance $L_2$ and the capacitance values of the microchip determined for voltages from 0V to $U_{op}$.

In any case, the inductance $L_2$ of the antenna of the contactless card 3 is required to determine the tuning quality of the contactless card 3, either in order to determine the operating resonance frequency $f_{op}$ or, in case the tuning quality is assessed by means of the non-operating resonance frequency $f_{nop}$, because the optimum non-operating resonance frequency $f_{nop\_opt}$ depends on the inductance $L_2$. The relationship between the optimum non-operating resonance frequency $f_{nop\_opt}$ and the inductance $L_2$ is given in good approximation according to the following formula:

$$f_{nop\_opt} \approx f_0 \left( 1 + \frac{1}{2} \omega_0^2 \cdot \Delta C \cdot L_2 \right) \quad (9)$$

where $\omega_0$ is the angular frequency corresponding to the carrier frequency $f_0$ and $\Delta C$ is the capacitance lift in the card microchip 32 when the voltage increases from 0V to $U_{op}$:

$$\Delta C = C_{op} - C_{nop} \quad (10)$$

$C_{op}$ is the operating capacitance of the card microchip 32, i.e. the capacitance at the voltage $U_{op}$. The difference of the non-operating resonance frequency $f_{nop}$ to its optimal non-operating resonance frequency $f_{nop\_opt}$ is then a measure of the tuning quality of the contactless card 3. If the non-operating resonance frequency $f_{nop}$ equals the optimal non-operating resonance frequency $f_{nop\_opt}$ as defined in equation (9), then it is guaranteed that the operating resonance frequency $f_{op}$ automatically equals the carrier frequency $f_0$, e.g. 13.56MHz.

After determining the inductance $L_2$, the capacitance $C_2$, and the resistance $R_2$ in particular of the antenna 31 of the contactless card 3, the required field strength $H_{op}$ required to operate the contactless card 3 can be determined. For this purpose, the contactless card 3 is arranged within a distance of about 25mm to 30mm from the pick-up probe 2. The axial inhomogeneities of the electromagnetic field of the pick-up probe 2 as shown in Fig. 1 c, for example, are relatively large, such that small changes in the distance between the antennas strongly change the field strength. In a distance of about 25mm to 30mm, the axial inhomogeneities of the electromagnetic field amount to about 5%-10%, which is sufficiently small with respect to the inaccuracy in the distance between the antennas of the pick-up probe 2 and of the contactless card 3. Moreover, in case of a distance of about 25mm to 30mm between the antennas, the capacitance between the antennas can be neglected.

Using measurements of the impedance of the pick-up probe 2 and an optimization procedure as described above, the mutual inductance M between the pick-up probe 2 and the contactless card 3 arranged at a distance of about 25mm to 30mm thereof can be determined. Thereafter, a precise computerized model of the arrangement is available and by simulation the source voltage of the impedance analyzer can be increased until the simulated voltage on the microchip of the contactless card 3 has reached the minimal operating voltage $U_{op}$. Using the geometry of the probe antenna 21 of the pick-up coil 1 and the current $I_1$ flowing in the probe antenna 21, the average field strength at a particular distance from the pick-up probe 2 can be calculated, which is the minimal required operating field strength $H_{op}$ of the contactless card 3. The geometry of the antenna of the contactless card 3 does not have to be known in order to determine the minimal operating field strength $H_{op}$ of the contactless card 3.

The tuning quality of the contactless card 3 is to be determined sufficiently accurate. In a variant, the tuning quality shall be determined such that the operating distance of the contactless card 3 is determined within an error of 10%. The operating distance is defined as the distance between the pick-up probe 2 and the contactless card 3 which leads to the minimal required voltage $U_{op}$ on the card microchip 32. In order to have the error of the operating distance sufficiently small, the error in determining the frequencies $f_{op}$, $f_{nop\_opt}$ and the inductivity $L_2$ has to be sufficiently small. The required accuracy in determining the inductivity $L_2$ depends on the type of microchip involved. For instance, from a curve showing the operating distance in function of the detuning for a particular card microchip type, it can be estimated how accurately the optimal non-operating resonance frequency $f_{nop\_opt}$ must be known in order to keep the error in the estimated value of the operating distance below, for example, 10%. With the aid of equation (9), it is then possible to estimate the required accuracy in $L_2$ for that particular card microchip type, so that the error in the operating distance estimated for the contactless card 3 based on the electrical parameters just found will not exceed, for example, 10%.

In good approximation, the microchip 32 of a contactless card 3 is modelled as a voltage controlled impedance. In a variant, the nonlinear behaviour of the impedance of the microchip 32 is used in the measuring method to determine electrical parameters of a contactless card 3, for example in order to determine the tuning quality. Hence, the impedance of the microchip 32 of the contactless card 3, for example of a RFID transponder, $Z_{chip}$ is to be determined. For contactless cards, various types of microchips are used. In a variant, for each type of a microchip the impedance is determined using an exemplary microchip 32, as the variations of the impedance of microchips of a certain type are small compared to the variations between different types of microchips. The impedance is to be determined for various source voltages in the range of $5mV_{rms}$ up to $5V_{rms}$ and for various frequencies in the range of 10MHz up to 20MHz. Known impedance analyzers operate with a source voltage of up to $1V_{rms}$, which is not sufficiently high.

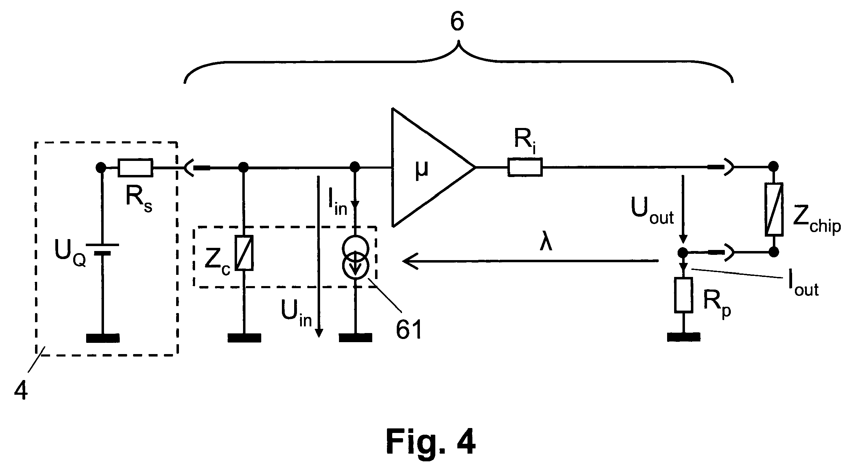

Figure 4 shows the equivalent circuit of an impedance mapping amplifier 6 configured to amplify the output voltage of an impedance analyzer and to measure the impedance of a microchip 32 at higher voltages. In Figure 4, the microchip impedance is denoted by $Z_{chip}$. As schematically shown in Figure 4, the impedance analyzer 4 includes a voltage source $U_Q$ and a output resistance $R_S$, e.g. of 25Ω. $U_{in}$ is the effective voltage which is generated by the impedance analyzer 4 at the input of the impedance mapping amplifier 6. The microchip impedance $Z_{chip}$ depends on the voltage $U_{out}$ at the output of the impedance mapping amplifier 6. The impedance mapping amplifier has a complex amplification, which is denoted by $\mu$ in Figure 4, and a output resistance $R_i$. The input voltage $U_{in}$ is amplified according to the complex amplification $\mu$ into the output voltage $U_{out}$. As schematically shown in Figure 4, using the shunt resistance $R_p$, a current source 61 of the impedance mapping amplifier 6 is controlled, such that the current at the input of the impedance mapping amplifier 6 depends on the current $I_{out}$ at the output of the impedance mapping amplifier 6. $Z_c$ denotes the output impedance of the current source 61, which ideally is infinity, but in reality is complex and frequency dependent. In a variant, the current source 61 is a voltage controlled bipolar current source. $\lambda$ denotes the complex current amplification factor $I_{out}/I_{in}$ of the impedance mapping amplifier 6. The impedance analyzer measures the impedance $U_{in}/I_{in}$.

The impedance mapping amplifier 6 amplifies first like an operational amplifier the input voltage $U_{in}$, and applies the output voltage $U_{out}$ to the microchip. A feedback is provided from the output of the impedance mapping amplifier 6 to the input on the basis of the voltage controlled current source 61. The output voltage $U_{out}$ is amplified by a factor $\mu = U_{out}/U_{in}$. The output current $I_{out}$ is amplified by a factor $\lambda = I_{out}/I_{in}$. In case the ratio $\kappa = \mu/\lambda$ has the value of 1, the impedance measured with the impedance analyzer at the input of the impedance mapping amplifier 6 would exactly be equal to the impedance of the microchip, wherein, depending on the factor $\mu$, the voltage applied at the microchip is correspondingly higher than the voltage provided by the impedance analyzer. However, in reality, the value of the ratio $\kappa$ always deviates from 1, so that its exact value must be known and taken into account in the calculation of $U_{out}$.

By a compensation, the impedance analyzer may be used to measure the impedance Z of the microchip also in case the ratio $\kappa$ is not equal to 1. The ratio $\kappa$ is to be known in order to determine the output voltage $U_{out}$ of the impedance mapping amplifier. The output voltage $U_{out}$ is determined according to the following equation, wherein $R_{ip}=R_i+R_p$.

$$U_{out} = \mu \cdot U_Q \cdot \left| \frac{Z}{R_S \cdot \left( \kappa + \frac{R_{ip} + Z}{Z_C} \right) + R_{ip} + Z} \right| \qquad (11)$$

The factor $\mu$ and the ratio $\kappa = \mu/\lambda$, which may be complex, but ideally is real and has the value 1, are to be determined for the complete frequency range, e.g. the frequency range 10MHz-20MHz, wherein normalized impedances are used, i.e. resistors, capacitors, and inductors of exactly known electrical properties, and wherein the measurement results are interpolated by polynomials of second order, for example. It is sufficient to measure the absolute value of the factor $\mu$ and to determine complex values only for the ratio $\kappa$. For a known, calibrated impedance Z, the following equation applies.

$$\kappa = \left( Z + R_{ip} \right) \cdot \left( \frac{1}{R + iX} - \frac{1}{Z_C} \right) \qquad (12)$$

The term R denotes the real part and the term X the imaginary part of the calibrated impedance Z, which is measured and displayed by the impedance analyzer. The measurement of R+iX is repeated for various calibrated impedances. According to equation (12), the frequency response of the ratio $\kappa$ is determined and interpolated for each calibrated impedance. Ideally, the ratio $\kappa$ is independent of the calibrated impedance. However, in reality, a certain statistical spread is involved, which is averaged, for example. In an analogous procedure, the absolute value of the factor $|\mu|$ is determined.

For certain microchips 32, the impedance $Z_{chip}$ can only be determined as a function of the current $I_{out}$, but not as a function of the voltage $U_{out}$. Accordingly, the impedance $Z_{chip}$ is consistently determined as a function of the current $I_{out}$.

The impedance $Z_{chip}(I, f)$ is determined for each frequency of interest and for a certain voltage sweep of $U_Q$. In a variant, $U_Q$ is set to 201 different values and 51 frequencies in the range of 10MHz-20MHz at a distance of 200kHz. As a result, relatively coarse measurements of the impedance $Z_{chip}$ are determined for 201 current values I and 51 frequency values f. In a variant, by interpolation, the impedance $Z_{chip}$ is determined for 1001 current values I and for 201 frequency values f.

Interpolation of the impedance $Z_{chip}$ is relatively difficult, mainly because of the following reasons:

- the impedance includes relatively flat regions, which suddenly break into steep regions, wherein even two-dimensional least square spline functions do not sufficiently describe the impedance, and

- the data points are not in a regular grid of current and frequency, as for a given voltage $U_Q$ the frequency dependence of the impedance leads to a deformation of the grid in the direction of the current, wherein the data points must be orthogonalized before interpolation, or an algorithm is to be used which does not require a regular grid.

In a variant, interpolation is performed using the following algorithm. The interpolation points, i.e. the points in the orthogonal current/frequency grid for which the impedance is to be calculated in the interpolation procedure, are scanned in a double loop, namely one loop for the index of current, and one loop for the index of frequency. In the inner loop, the square of the Euclidian distance of the actual interpolation point to all measured points, i.e. to the points in the non-orthogonal, distorted current/frequency grid for which the impedance is known from measurement, is calculated, and the indices of the measured point with minimum distance to the actual interpolation point are sought.

A number of "nfi" interpolation points below and above the measured point with minimum distance are selected in the frequency direction (i.e. totally 2*nfi+1 points), and "nli" (i.e. totally 2*nli+1 points) in the current direction, and gathered in a submatrix of interpolation points surrounding the actual interpolation point. Since "nfi" and "nli" may differ, the filtering effect may be anisotropic. In a variant, good results are achieved with nfi = 3 and nli = 10.

In a variant, it is checked whether for indices resulting from this selection procedure measured points do in fact exist. If any index in the two index vectors constructed as described above would point to a non-existing element in the matrix of measurement data, the corresponding indices are either increased or decreased so that all resulting indices do indeed point to existing measurement data.

Then the submatrices of the selected interpolation points for frequency, current, and impedance are extracted from the corresponding matrices of frequency, current and impedance values given by the measurement. The submatrices are transposed and transformed to column vectors. These vectors are passed to the function "SurfaceSplineFit", which performs a least-squares fit of a two-dimensional spline, i.e. a bi-cubic spline or surface spline, according to the state of the art. The function is called separately for the real and imaginary part of the impedance, together with the actual interpolation frequency and current at which the spline is evaluated in the double loop. Thus, for each interpolation point, a local subsurface of (2*nli+1)x(2*nfi+1) interpolation points is taken into account, namely 2*nfi+1 points in frequency direction horizontally, and 2*nli+1 points in current direction vertically. At the end of the inner loop, the single interpolated impedance value is assigned to the actual loop element of the final impedance interpolation matrix.

This algorithm provides for the interpolation of surfaces with sudden gradient changes and very steep slopes, in particular for measurement data which is in the form of an irregular grid.

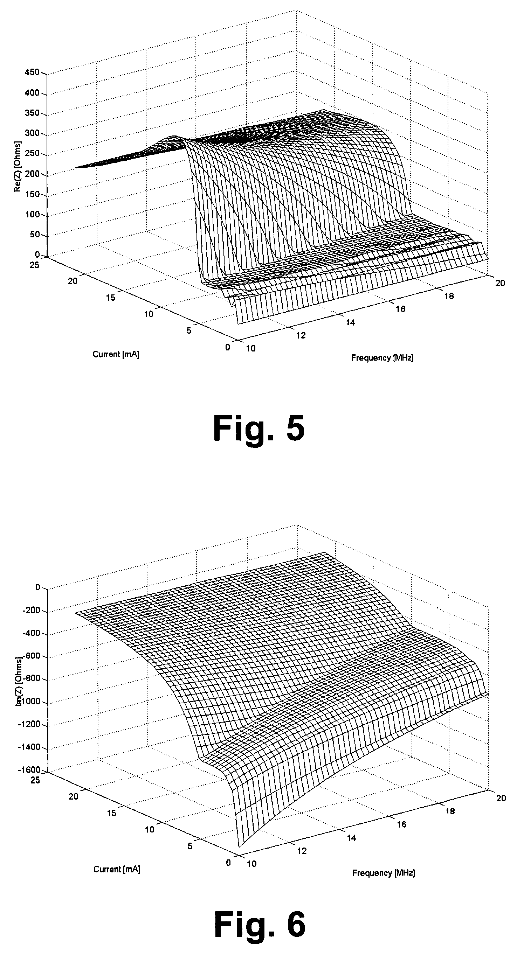

Figure 5 shows an example measurement of the real part of the impedance $Z_{chip}$ of a microchip 32 for various currents and frequencies, wherein the impedance is orthogonalized and interpolated as described above.

Figure 6 shows an example measurement of the imaginary part of the impedance $Z_{chip}$ of a microchip 32 for various currents and frequencies, wherein the impedance is orthogonalized and interpolated as described above.

In a variant, on the basis of the impedance $Z_{chip}(l,f)$, an equivalent, current and frequency dependent parallel resistance and an equivalent, current and frequency dependent parallel capacitance is calculated.

Figure 7 shows schematically exemplary steps for determining one or more electrical parameters of a contactless data storage device. In step S1, impedance data of a pick-up probe 2 interacting via an electromagnetic field with the contactless data storage device 3 is measured and measured impedance data is determined as a function of at least one of: frequency, current, and voltage. In step S2, impedance data of a computerized model of the pick-up probe interacting via a modelled electromagnetic field with a computerized model of the contactless data storage device is calculated, wherein calculated impedance data is determined as a function of one or more electrical parameters of the computerized model of the contactless data storage device and as a function of at least one of: frequency, current, and voltage. In step S3, an objective function is generated using measured impedance data and using corresponding calculated impedance data. In step S4, an optimal solution for the objective function is determined and using the optimal solution the one or more electrical parameters of the contactless data storage device are determined.

**REFERENCE SIGNS**

| | |
|---|---|
| 1 | Apparatus for determining electrical parameters of a contactless card |
| 2 | pick-up probe |
| 21 | probe antenna |
| 22 | probe connection |
| 3 | contactless data storage device, also called "contactless card" |
| 31 | card antenna |
| 32 | card microchip |
| 4 | impedance analyzer |
| 51 | simulator unit |
| 52 | function generator |
| 53 | optimizer unit |
| 6 | impedance mapping amplifier |
| 61 | voltage controlled bipolar current source |

**Claims**

1. An apparatus (1) for determining one or more electrical parameters of a contactless data storage device (3) which includes a card antenna (31) with a coil of one or more windings connected to a card microchip (32), the apparatus comprising:

an impedance analyzer (4) configured to measure impedance data of a pick-up probe (2) interacting via an electromagnetic field with the contactless data storage device (3) and to determine measured impedance data as a function of at least one of: frequency, current, and voltage;
a simulator unit (51) configured to determine calculated impedance data of a computerized model of the pick-up probe (2) interacting via a modelled electromagnetic field with a computerized model of the contactless data storage device (3), the calculated impedance data being determined as a function of one or more electrical parameters of the computerized model of the contactless data storage device (3) and as a function of at least one of: frequency, current, and voltage;

a function generator (52) configured to generate an objective function using the measured impedance data and using the calculated impedance data; and

an optimizer unit (53) configured to calculate an optimal solution for the objective function and to use the optimal solution to determine the one or more electrical parameters of the contactless data storage device (3).

2. The apparatus according to claim 1, wherein the simulator unit (51) includes a data store configured to store one or more exemplary impedance data sets of one or more exemplary microchips (32) of contactless data storage devices, an exemplary impedance data set being stored as a function of at least one of: frequency, current, and voltage; and, depending on the microchip (32) included in the contactless data storage device (3), one of the stored exemplary impedance data sets is used to calculate the impedance data of the computerized model of the pick-up probe.

3. The apparatus according to claim 1 or 2, wherein the simulator unit (51) includes one or more approximation units each configured to approximate an electrical parameter of the contactless data storage device (3), the approximated electrical parameter depending on one or more electrical parameters of the contactless data storage device (3).

4. The apparatus according to one of claims 1 to 3, wherein the function generator (52) is configured to generate the objective function using only the imaginary part of the measured impedance data and the imaginary part of the calculated impedance data.

5. The apparatus according to one of claims 1 to 4, wherein the optimizer unit (53) is configured to determine the one or more electrical parameters of the contactless data storage device (3) with an accuracy which depends on one or more parameters of the contactless data storage device (3), in particular on one or more parameters of a microchip (32) of the contactless data storage device (3).

6. The apparatus according to one of claims 1 to 5, further comprising a tuning quality calculator configured to use the one or more electrical parameters of the contactless data storage device (3) to calculate a tuning quality of the contactless data storage device (3).

7. The apparatus according to one of claims 1 to 6, further comprising a required operating field strength calculator configured to use the one or more determined electrical parameters of the contactless data storage device (3) to calculate a minimal required operating field strength $H_{op}$ of the contactless data storage device (3).

8. The apparatus according to one of claims 1 to 7, further comprising an impedance mapping amplifier (6) configured to amplify the output voltage of an impedance analyzer (4) such that by the impedance analyzer (4) the impedance of an exemplary microchip (32) is measured at higher voltages than provided by the impedance analyzer (4), wherein in particular the impedance mapping amplifier (6) is configured to amplify an input voltage $U_{in}$ to the impedance mapping amplifier (6) by a complex factor $\mu$ to an output voltage $U_{out} = \mu\, U_{in}$ and to amplify an input current $I_{in}$ to the impedance mapping amplifier (6) by a complex factor $\lambda$ to an output current $I_{out} = \lambda\, I_{in}$, wherein preferably $\mu/\lambda = 1$.

9. A method of determining one or more electrical parameters of a contactless data storage device (3) which includes a card antenna (31) with a coil of one or more windings connected to a card microchip (32), the method comprising:

measuring impedance data of a pick-up probe (2) interacting via an electromagnetic field with the contactless data storage device (3) and determining measured impedance data as a function of at least one of: frequency, current, and voltage;

calculating impedance data of a computerized model of the pick-up probe (2) interacting via a modelled electromagnetic field with a computerized model of the contactless data storage device (3), the calculated impedance data being determined as a function of one or more electrical parameters of the computerized model of the contactless data storage device (3) and as a function of at least one of: frequency, current, and voltage;

generating an objective function using the measured impedance data and using the calculated impedance data; and

calculating an optimal solution for the objective function and using the optimal solution to determine the one or more electrical parameters of the contactless data storage device (3).

10. The method according to claim 9, further comprising: storing in a data store one or more exemplary impedance data sets of one or more exemplary microchips (32) of contactless data storage devices (3), an exemplary impedance being stored as a function of at least one of: frequency, current, and voltage; and, depending on the microchip (32) included in the contactless data storage device (3), using one of the stored exemplary impedance data sets to calculate the impedance data of the computerized model of the pick-up probe.

11. The method according to claim 9 or 10, further comprising: approximating an electrical parameter of the contactless data storage device (3), the approximated electrical parameter depending on one or more electrical parameters of the contactless data storage device (3).

12. The method according to one of claims 9 to 11, wherein generating the objective function is performed using only the imaginary part of the measured impedance data and the imaginary part of the calculated impedance data.

13. The method according to one of claims 9 to 12, wherein one or more electrical parameters of the contactless data storage device (3) is determined with an accuracy which depends on one or more parameters of the contactless data storage device (3), in particular on one or more parameters of a microchip (32) of the contactless data storage device (3).

14. The method according to one of claims 9 to 13, further comprising: using the one or more determined electrical parameters of the contactless data storage device (3) to calculate a tuning quality of the contactless data storage device (3).

15. The method according to one of claims 9 to 14, further comprising: using the one or more electrical parameters of the contactless data storage device (3) to calculate a minimal required operating field strength $H_{op}$ of the contactless data storage device (3).

16. Computer program product comprising a computer readable medium having stored thereon computer program code for controlling one or more processors of an apparatus (1) for determining one or more electrical parameters of a contactless data storage device (3) which includes a card antenna (31) with a coil of one or more windings connected to a card microchip (32), the computer program code being configured to direct the apparatus (1) to:

measure impedance data of a pick-up probe (2) interacting via an electromagnetic field with the contactless data storage device (3) and determine measured impedance data as a function of at least one of: frequency, current, and voltage;
calculate impedance data of a computerized model of the pick-up probe (2) interacting via a modelled electromagnetic field with a computerized model of the contactless data storage device (3), the calculated impedance data being determined as a function of one or more electrical parameters of the computerized model of the contactless data storage device (3) and as a function of at least one of: frequency, current, and voltage;
generate an objective function using the measured impedance data and using the calculated impedance data; and
calculate an optimal solution for the objective function and using the optimal solution to determine the one or more electrical parameters of the contactless data storage device (3).

**Patentansprüche**

1. Vorrichtung (1) zum Bestimmen eines oder mehrerer elektrischer Parameter einer kontaktlosen Datenspeichervorrichtung (3), die eine Kartenantenne (31) mit einer Spule mit einer oder mehreren Windungen, die mit einem Kartenmikrochip (32) verbunden ist, enthält, wobei die Vorrichtung Folgendes umfasst:

einen Impedanzanalysator (4), der konfiguriert ist, Impedanzdaten einer Aufnahmesonde (2), die über ein elektromagnetisches Feld mit der kontaktlosen Datenspeichervorrichtung (3) wechselwirkt, zu messen und gemessene Impedanzdaten als eine Funktion mindestens eines der Folgenden zu bestimmen: Frequenz, Strom und Spannung;
eine Simulatoreinheit (51), die konfiguriert ist, berechnete Impedanzdaten eines computerbasierten Modells der Aufnahmesonde (2), die über ein modelliertes elektromagnetisches Feld mit einem computerbasierten Modell der kontaktlosen Datenspeichervorrichtung (3) wechselwirkt, zu bestimmen, wobei die berechneten Impedanzdaten als eine Funktion eines oder mehrerer elektrischer Parameter des computerbasierten Modells der kontaktlosen Datenspeichervorrichtung (3) und als eine Funktion mindestens eines der Folgenden bestimmt wird: Frequenz, Strom und Spannung;
einen Funktionsgenerator (52), der konfiguriert ist, eine Zielfunktion unter Verwendung der gemessenen Impedanzdaten und unter Verwendung der berechneten Impedanzdaten zu erzeugen; und
eine Optimierereinheit (53), die konfiguriert ist, eine optimale Lösung für die Zielfunktion zu berechnen und die optimale Lösung zu verwenden, um den einen oder die mehreren elektrischen Parameter der kontaktlosen Datenspeichervorrichtung (3) zu bestimmen.

2. Vorrichtung nach Anspruch 1, wobei die Simulatoreinheit (51) einen Datenspeicher enthält, der konfiguriert ist, eine oder mehrere exemplarische Impedanzdatengruppen eines oder mehrerer exemplarischer Mikrochips (32) von kontaktlosen Datenspeichervorrichtungen zu bestimmen, wobei eine exemplarische Impedanzdatengruppe als eine Funktion mindestens eines der Folgenden gespeichert wird: Frequenz, Strom und Spannung; und abhängig von dem Mikrochip (32), der in der kontaktlosen Datenspeichervorrichtung (3) enthalten ist, eine der gespeicherten exemplarischen Impedanzdatengruppen verwendet wird, um die Impedanzdaten des computerbasierten Modells der Aufnahmesonde zu berechnen.

3. Vorrichtung nach Anspruch 1 oder 2, wobei die Simulatoreinheit (51) eine oder mehrere Approximationseinheiten enthält, die jeweils konfiguriert sind, einen elektrischen Parameter der kontaktlosen Datenspeichervorrichtung (3) zu approximieren, wobei der approximierte elektrische Parameter von einem oder mehreren elektrischen Parametern der kontaktlosen Datenspeichervorrichtung (3) abhängt.

4. Vorrichtung nach einem der Ansprüche 1 bis 3, wobei der Funktionsgenerator (52) konfiguriert ist, die Zielfunktion nur unter Verwendung des imaginären Teils der gemessenen Impedanzdaten und des imaginären Teils der berechneten Impedanzdaten zu erzeugen.

5. Vorrichtung nach einem der Ansprüche 1 bis 4, wobei die Optimierereinheit (53) konfiguriert ist, den einen oder die mehreren elektrischen Parameter der kontaktlosen Datenspeichervorrichtung (3) mit einer Genauigkeit zu bestimmen, die von einem oder mehreren Parametern der kontaktlosen Datenspeichervorrichtung (3), insbesondere von einem oder mehreren Parametern eines Mikrochips (32) der kontaktlosen Datenspeichervorrichtung (3), abhängt.

6. Vorrichtung nach einem der Ansprüche 1 bis 5, die ferner einen Abstimmqualitätsrechner umfasst, der konfiguriert ist, den einen oder die mehreren elektrischen Parameter der kontaktlosen Datenspeichervorrichtung (3) zu verwenden, um eine Abstimmqualität der kontaktlosen Datenspeichervorrichtung (3) zu berechnen.

7. Vorrichtung nach einem der Ansprüche 1 bis 6, die ferner einen Rechner für die benötigte Betriebsfeldstärke umfasst, der konfiguriert ist, den einen oder die mehreren bestimmten elektrischen Parameter der kontaktlosen Datenspeichervorrichtung (3) zu verwenden, um eine minimal benötigte Betriebsfeldstärke $H_{op}$ der kontaktlosen Datenspeichervorrichtung (3) zu berechnen.

8. Vorrichtung nach einem der Ansprüche 1 bis 7, die ferner einen Impedanzabbildungsverstärker (6) umfasst, der konfiguriert ist, die Ausgangsspannung eines Impedanzanalysators (4) derart zu verstärken, dass durch den Impedanzanalysator (4) die Impedanz eines exemplarischen Mikrochips (32) bei höheren Spannungen gemessen wird als durch den Impedanzanalysator (4) bereitgestellt werden, wobei insbesondere der Impedanzabbildungsverstärker (6) konfiguriert ist, eine Eingangsspannung Uin in den Impedanzabbildungsverstärker (6) um einen komplexen Faktor $\mu$ zu einer Ausgangsspannung $U_{out} = \mu U_{in}$ zu verstärken und einen Eingangsstrom $I_{in}$ in den Impedanzabbildungsverstärker (6) um einen komplexen Faktor $\lambda$ zu einem Ausgangsstrom $I_{out} = \lambda I_{in}$ zu verstärken, wobei vorzugsweise $\mu/\lambda = 1$.

9. Verfahren zum Bestimmen eines oder mehrerer elektrischer Parameter einer kontaktlosen Datenspeichervorrichtung (3), die eine Kartenantenne (31) mit einer Spule einer oder mehrerer Windungen, die mit einem Kartenmikrochip (32) verbunden sind, enthält, wobei das Verfahren Folgendes umfasst:

Messen von Impedanzdaten einer Aufnahmesonde (2), die über ein elektromagnetisches Feld mit der kontaktlosen Datenspeichervorrichtung (3) wechselwirkt, und Bestimmen von gemessenen Impedanzdaten als eine Funktion mindestens eines der Folgenden: Frequenz, Strom und Spannung;
Berechnen von Impedanzdaten eines computerbasierten Modells der Aufnahmesonde (2), die über ein modelliertes elektromagnetisches Feld mit einem computerbasierten Modell der kontaktlosen Datenspeichervorrichtung (3) wechselwirkt, wobei die berechneten Impedanzdaten als eine Funktion eines oder mehrerer elektrischer Parameter des computerbasierten Modells der kontaktlosen Datenspeichervorrichtung (3) und als eine Funktion mindestens eines der Folgenden bestimmt wird: Frequenz, Strom und Spannung;

Erzeugen einer Zielfunktion unter Verwendung der gemessenen Impedanzdaten und unter Verwendung der berechneten Impedanzdaten; und

Berechnen einer optimalen Lösung für die Zielfunktion und Verwenden der optimalen Lösung, um den einen oder die mehreren elektrischen Parameter der kontaktlosen Datenspeichervorrichtung (3) zu bestimmen.

**10.** Verfahren nach Anspruch 9, das ferner Folgendes umfasst: Speichern in einem Datenspeicher einer oder mehrerer exemplarischer Impedanzdatengruppen eines oder mehrerer exemplarischer Mikrochips (32) von kontaktlosen Datenspeichervorrichtungen (3), wobei eine exemplarische Impedanz als eine Funktion mindestens eines der Folgenden gespeichert wird: Frequenz, Strom und Spannung; und abhängig von dem Mikrochip (32), der in der kontaktlosen Datenspeichervorrichtung (3) enthalten ist, Verwenden einer der gespeicherten exemplarischen Impedanzdatengruppen, um die Impedanzdaten des computerbasierten Modells der Aufnahmesonde zu berechnen.

**11.** Verfahren nach Anspruch 9 oder 10, das ferner Folgendes umfasst: Approximieren eines elektrischen Parameters der kontaktlosen Datenspeichervorrichtung (3), wobei der approximierte elektrische Parameter von einem oder mehreren elektrischen Parametern der kontaktlosen Datenspeichervorrichtung (3) abhängt.

**12.** Verfahren nach einem der Ansprüche 9 bis 11, wobei das Erzeugen der Zielfunktion nur unter Verwendung des imaginären Teils der gemessenen Impedanzdaten und des imaginären Teils der berechneten Impedanzdaten ausgeführt wird.

**13.** Verfahren nach einem der Ansprüche 9 bis 12, wobei ein oder mehrere elektrische Parameter der kontaktlosen Datenspeichervorrichtung (3) mit einer Genauigkeit bestimmt werden, die von einem oder mehreren Parametern der kontaktlosen Datenspeichervorrichtung (3), insbesondere von einem oder mehreren Parametern eines Mikrochips (32) der kontaktlosen Datenspeichervorrichtung (3), abhängt.

**14.** Verfahren nach einem der Ansprüche 9 bis 13, das ferner Folgendes umfasst: Verwenden des einen oder der mehreren bestimmten elektrischen Parameter der kontaktlosen Datenspeichervorrichtung (3), um eine Abstimmqualität der kontaktlosen Datenspeichervorrichtung (3) zu berechnen.

**15.** Verfahren nach einem der Ansprüche 9 bis 14, das ferner Folgendes umfasst: Verwenden des einen oder der mehreren elektrischen Parameter der kontaktlosen Datenspeichervorrichtung (3), um eine minimal benötigte Betriebsfeldstärke $H_{op}$ der kontaktlosen Datenspeichervorrichtung (3) zu berechnen.

**16.** Computerprogrammprodukt, das ein computerlesbares Medium mit einem darauf gespeicherten Computerprogrammcode zum Steuern eines oder mehrerer Prozessoren einer Vorrichtung (1) zum Bestimmen eines oder mehrerer elektrischer Parameter einer kontaktlosen Datenspeichervorrichtung (3) umfasst, die eine Kartenantenne (31) mit einer Spule mit einer oder mehreren Windungen, die mit einem Kartenmikrochip (32) verbunden ist, enthält, wobei der Computerprogrammcode konfiguriert ist, die Vorrichtung (1) anzuweisen:

Impedanzdaten einer Aufnahmesonde (2), die über ein elektromagnetisches Feld mit der kontaktlosen Datenspeichervorrichtung (3) wechselwirkt, zu messen und gemessene Impedanzdaten als eine Funktion mindestens eines der Folgenden zu bestimmen: Frequenz, Strom und Spannung;

Impedanzdaten eines computerbasierten Modells der Aufnahmesonde (2), die über ein modelliertes elektromagnetisches Feld mit einem computerbasierten Modell der kontaktlosen Datenspeichervorrichtung (3) wechselwirkt, zu bestimmen, wobei die berechneten Impendanzdaten als eine Funktion eines oder mehrerer elektrischer Parameter des computerbasierten Modells der kontaktlosen Datenspeichervorrichtung (3) und als eine Funktion mindestens eines der Folgenden bestimmt wird: Frequenz, Strom und Spannung;

eine Zielfunktion unter Verwendung der gemessenen Impedanzdaten und unter Verwendung der berechneten Impedanzdaten zu erzeugen; und

eine optimale Lösung für die Zielfunktion zu berechnen und die optimale Lösung zu verwenden, um den einen oder die mehreren elektrischen Parameter der kontaktlosen Datenspeichervorrichtung (3) zu bestimmen.

## Revendications

**1.** Appareil (1) pour déterminer un ou plusieurs paramètres électriques d'un dispositif de stockage de données sans contact (3) qui comprend une antenne carte (31) avec une bobine d'un ou plusieurs bobinages connectée à une micropuce de carte (32), l'appareil comprenant :

un analyseur d'impédance (4) configuré pour mesurer des données d'impédance d'une sonde de prélèvement (2) interagissant par l'intermédiaire d'un champ électromagnétique avec le dispositif de stockage de données sans contact (3) et pour déterminer des données d'impédance mesurées sous la forme d'une fonction d'au moins un paramètre parmi les suivants : la fréquence, le courant et la tension ;

une unité de simulateur (51) configurée pour déterminer des données d'impédance calculées d'un modèle informatisé de la sonde de prélèvement (2) interagissant par l'intermédiaire d'un champ électromagnétique modélisé avec un modèle informatisé du dispositif de stockage de données sans contact (3), les données d'impédance calculées étant déterminées sous la forme d'une fonction d'un ou plusieurs paramètres électriques du modèle informatisé du dispositif de stockage de données sans contact (3) et sous la forme d'une fonction d'au moins un paramètre parmi les suivants : la fréquence, le courant et la tension ;

un générateur de fonction (52) configuré pour générer une fonction d'objectif au moyen des données d'impédance mesurées et au moyen des données d'impédance calculées ; et

une unité d'optimiseur (53) configurée pour calculer une solution optimale pour la fonction d'objectif et pour utiliser la solution optimale pour déterminer le ou les paramètres électriques du dispositif de stockage de données sans contact (3).

2. Appareil selon la revendication 1, dans lequel l'unité de simulateur (51) comprend un magasin de données configuré pour stocker un ou plusieurs ensembles de données d'impédance exemplaires d'une ou plusieurs micropuces exemplaires (32) de dispositifs de stockage de données sans contact, un ensemble de données d'impédance exemplaire étant stocké sous la forme d'une fonction d'au moins un paramètre parmi les suivants : la fréquence, le courant et la tension ; et, en fonction de la micropuce (32) incluse dans le dispositif de stockage de données sans contact (3), un des ensembles de données d'impédance exemplaires stockés est utilisé pour calculer les données d'impédance du modèle informatisé de la sonde de prélèvement.

3. Appareil selon la revendication 1 ou la revendication 2, dans lequel l'unité de simulateur (51) comprend une ou plusieurs unités d'approximation, chacune configurée pour approximer un paramètre électrique du dispositif de stockage de données sans contact (3), le paramètre électrique approximé dépendant d'un ou plusieurs paramètres électriques du dispositif de stockage de données sans contact (3).

4. Appareil selon l'une des revendications 1 à 3, dans lequel le générateur de fonction (52) est configuré pour générer la fonction d'objectif en utilisant uniquement la partie imaginaire des données d'impédance mesurées et la partie imaginaire des données d'impédance calculées.

5. Appareil selon l'une des revendications 1 à 4, dans lequel l'unité d'optimiseur (53) est configurée pour déterminer le ou les paramètres électriques du dispositif de stockage de données sans contact (3) avec une précision qui dépend d'un ou de plusieurs paramètres du dispositif de stockage de données sans contact (3), en particulier d'un ou de plusieurs paramètres d'une micropuce (32) du dispositif de stockage de données sans contact (3).

6. Appareil selon l'une des revendications 1 à 5, comprenant en outre un calculateur de qualité de réglage configuré pour utiliser le ou les paramètres électriques du dispositif de stockage de données sans contact (3) pour calculer une qualité de réglage du dispositif de stockage de données sans contact (3).

7. Appareil selon l'une des revendications 1 à 6, comprenant en outre un calculateur d'intensité de champ d'exploitation requise configuré pour utiliser le ou les paramètres électriques déterminés du dispositif de stockage de données sans contact (3) pour calculer une intensité de champ d'exploitation requise minimale $H_{op}$ du dispositif de stockage de données sans contact (3).

8. Appareil selon l'une des revendications 1 à 7, comprenant en outre un amplificateur de mappage d'impédance (6) configuré pour amplifier la tension de sortie d'un analyseur d'impédance (4) de sorte que, par l'analyseur d'impédance (4), l'impédance d'une micropuce exemplaire (32) soit mesurée à des tensions plus élevées que celles fournies par l'analyseur d'impédance (4), où, en particulier, l'amplificateur de mappage d'impédance (6) est configuré pour amplifier une tension d'entrée $U_{in}$ dans l'amplificateur de mappage d'impédance (6) d'un facteur complexe $\mu$ à une tension de sortie $U_{out} = \mu U_{in}$ et pour amplifier un courant d'entrée $I_{in}$ dans l'amplificateur de mappage d'impédance (6) d'un facteur complexe $\lambda$ à un courant de sortie $I_{out} = \lambda I_{in}$ où, de préférence $\mu/\lambda = 1$.

9. Procédé pour déterminer un ou plusieurs paramètres électriques d'un dispositif de stockage de données sans contact (3), qui comprend une antenne carte (31) avec une bobine d'un ou plusieurs bobinages connectée à une micropuce de carte (32), le procédé comprenant les étapes suivantes :

mesurer des données d'impédance d'une sonde de prélèvement (2) interagissant par l'intermédiaire d'un champ électromagnétique avec le dispositif de stockage de données sans contact (3) et déterminer des données d'impédance mesurées sous la forme d'une fonction d'au moins un paramètre parmi les suivants : la fréquence, le courant et la tension ;

calculer des données d'impédance d'un modèle informatisé de la sonde de prélèvement (2) interagissant par l'intermédiaire d'un champ électromagnétique modélisé avec un modèle informatisé du dispositif de stockage de données sans contact (3), les données d'impédance calculées étant déterminées sous la forme d'une fonction d'un ou plusieurs paramètres électriques du modèle informatisé du dispositif de stockage de données sans contact (3) et sous la forme d'une fonction d'au moins un paramètre parmi les suivants : la fréquence, le courant et la tension ;

générer une fonction d'objectif au moyen des données d'impédance mesurées et au moyen des données d'impédance calculées ; et

calculer une solution optimale pour la fonction d'objectif et utiliser la solution optimale pour déterminer le ou les paramètres électriques du dispositif de stockage de données sans contact (3).

10. Procédé selon la revendication 9, comprenant en outre les étapes suivantes : stocker, dans un magasin de données, un ou plusieurs ensembles de données d'impédance exemplaires d'une ou plusieurs micropuces exemplaires (32) de dispositifs de stockage de données sans contact (3), une impédance exemplaire étant stockée sous la forme d'une fonction d'au moins un paramètre parmi les suivants : la fréquence, le courant et la tension ; et, en fonction de la micropuce (32) incluse dans le dispositif de stockage de données sans contact (3), utiliser un des ensembles de données d'impédance exemplaires stockés pour calculer les données d'impédance du modèle informatisé de la sonde de prélèvement.

11. Procédé selon la revendication 9 ou la revendication 10, comprenant en outre les étapes suivantes : approximer un paramètre électrique du dispositif de stockage de données sans contact (3), le paramètre électrique approximé dépendant d'un ou plusieurs paramètres électriques du dispositif de stockage de données sans contact (3).

12. Procédé selon une des revendications 9 à 11, dans lequel la génération de la fonction d'objectif est effectuée en utilisant uniquement la partie imaginaire des données d'impédance mesurées et la partie imaginaire des données d'impédance calculées.

13. Procédé selon une des revendications 9 à 12, dans lequel le ou les paramètres électriques du dispositif de stockage de données sans contact (3) sont déterminés avec une précision qui dépend d'un ou de plusieurs paramètres du dispositif de stockage de données sans contact (3), en particulier d'un ou de plusieurs paramètres d'une micropuce (32) du dispositif de stockage de données sans contact (3).

14. Procédé selon une des revendications 9 à 13, comprenant en outre l'étape suivante : utiliser le ou les paramètres électriques déterminés du dispositif de stockage de données sans contact (3) pour calculer une qualité de réglage du dispositif de stockage de données sans contact (3).

15. Procédé selon une des revendications 9 à 14, comprenant en outre l'étape suivante : utiliser le ou les paramètres électriques du dispositif de stockage de données sans contact (3) pour calculer une intensité de champ d'exploitation requise minimale $H_{op}$ du dispositif de stockage de données sans contact (3).

16. Produit programme informatique comprenant un support lisible par ordinateur sur lequel est stocké un code de programme informatique pour contrôler un ou plusieurs processeurs d'un appareil (1) pour déterminer un ou plusieurs paramètres électriques d'un dispositif de stockage de données sans contact (3) qui comprend une antenne carte (31) avec une bobine d'un ou plusieurs bobinages connectée à une micropuce de carte (32), le code de programme informatique étant configuré pour amener l'appareil (1) à :

mesurer des données d'impédance d'une sonde de prélèvement (2) interagissant par l'intermédiaire d'un champ électromagnétique avec le dispositif de stockage de données sans contact (3) et déterminer des données d'impédance mesurées sous la forme d'une fonction d'au moins un paramètre parmi les suivants : la fréquence, le courant et la tension ;

calculer des données d'impédance d'un modèle informatisé de la sonde de prélèvement (2) interagissant par l'intermédiaire d'un champ électromagnétique modélisé avec un modèle informatisé du dispositif de stockage de données sans contact (3), les données d'impédance calculées étant déterminées sous la forme d'une fonction d'un ou plusieurs paramètres électriques du modèle informatisé du dispositif de stockage de données sans contact (3) et sous la forme d'une fonction d'au moins un paramètre parmi les suivants : la fréquence, le courant et la tension ;

générer une fonction d'objectif au moyen des données d'impédance mesurées et au moyen des données d'impédance calculées ; et calculer une solution optimale pour la fonction d'objectif et utiliser la solution optimale pour déterminer le ou les paramètres électriques du dispositif de stockage de données sans contact (3).

**Fig. 1a**

**Fig. 1b**

**Fig. 1c**

EP 2 706 485 B1

Fig. 3

Fig. 4

# Fig. 2

S1 — Measure impedance data

S2 — Calculate impedance data

S3 — Generate objective function

S4 — Determine optimal solution and electrical parameters

# Fig. 7

**Fig. 5**

**Fig. 6**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005086279 A